# EUROPÄISCHE PATENTSCHRIFT

(11) **EP 0 403 744 B1**
(45) Veröffentlichungstag und Bekanntmachung des Hinweises auf die Patenterteilung: **22.02.1995**
(21) Anmeldenummer: 90106726.4
(22) Anmeldetag: 07.04.1990
(51) Int. Cl.: H04H 1/00, H03J 7/18

(54) **RDS-Rundfunkempfänger mit empirisch wachsendem Speicherinhalt seiner Programmspeicher**
RDS broadcast receiver with empirically growing memory contents in its program memories
Récepteur de radiodiffusion équipé du RDS avec augmentation empirique du contenu de ses mémoires de programme

(30) Priorität: 21.06.1989 DE 3920220
(43) Veröffentlichungstag der Anmeldung: 27.12.1990
(73) Patentinhaber: GRUNDIG E.M.V. Elektro-Mechanische Versuchsanstalt Max Grundig holländ. Stiftung & Co. KG., D-90762 Fürth (DE)
(72) Erfinder: Kagerbauer, Gottfried, Dipl.-Ing., Grundig E.M.V., Kurgartenstrasse 37, D-8510 Fürth/Bay (DE); Kalmer, Mathias, Dipl.-Ing., Grundig E.M.V., Kurgartenstrasse 37, D-8510 Fürth/Bay (DE)

(56) Entgegenhaltungen:
- EP-A- 0 305 172
- DE-A- 3 222 025

## Beschreibung

Die Erfindung betrifft einen Rundfunkdaten (RDS)-Empfänger, insbesondere ein RDS-Autoradio, mit Programmspeichern, deren Speicherinhalt empirisch den individuellen Bedürfnissen angepaßt wird, dadurch, daß alternative Frequenzen (AF) der unter gleichem PI-Code (Programmidentifikations-Code) ausgestrahlten Programme aus anderen Speichern und/oder Speicherebenen automatisch übernommen werden, sobald diese Frequenzen bei einer betriebs- oder routinemäßigen Abstimmung des Empfängers auf ihre RDS-Empfangsqualität hin überprüft werden und bestimmte Mindestanforderungen erfüllen.

Aus der DE 32 22 025 A1 ist Rundfunkempfänger für Fahrzeuge bekannt. Dieser weist eine Schaltungsanordnung auf, die es ermöglicht, automatisch eine Sendefrequenz mit maximaler Feldstärke des empfangenen Programms einzustellen. Hierfür weist der Rundfunkempfänger einen Empfangssignalpegeldetektor, eine Detektorschaltung, eine Steuereinheit und einen Speicher auf. Die Steuereinheit veranlaßt bei durch die Detektorschaltung festgestellter Signalanteil-Abwesenheit eine Neuabstimmung des Tuners auf eine Ersatzstation. Falls dabei ein größerer Signalpegel der Ersatzstation festgestellt wird, werden die Daten der Stationen im Speicher ausgetauscht und so die Ersatzstation fortlaufend empfangen. Bei diesem Vorgang wird der gesamte Empfangsfrequenzbereich gescannt und es werden nur Empfangspegel gleicher Empfangssignale verglichen.

Bekanntlich wird beim Rundfunkdatensystem eine Hilfsträgerfrequenz von 57 kHz kontinuierlich mit einem binären Datenstrom in Quadratur amplitudenmoduliert. Der Datenstrom enthält u.a. folgende Informationen:
- PI-Code (Programme Identification) zur Kennzeichnung der Zugehörigkeit einer empfangenen Frequenz zu einer bestimmten Programmkette.
- PS-Code (Programme Service Name) zur alphanumerischen Darstellung des Sendernamens im Display des Empfangsgerätes.
- AF-Code (Alternative Frequencies) zur Übermittlung zusätzlicher Frequenzen, auf denen das gleiche Programm ausgestrahlt wird.
- TP-Code (Traffic Programme) zur Kennzeichnung von Verkehrsfunksendern.
- TA-Code (Traffic Announcement) als Begleitsignal einer Verkehrsfunkdurchsage.

Für das Aussenden der Daten für die alternativen Frequenzen bestehen zwei Verfahren.

Beim ersten Verfahren A senden der Hauptsender und die angeschlossenen Stationen einer Programmkette nur eine einzige AF-Liste mit bis zu 25 Frequenzen, ohne Rücksicht darauf, ob alle Frequenzen in einem begrenzten lokalen Sendegebiet empfangbar sind.

Beim zweiten Verfahren B wird von jedem Sender der Programmkette die gleiche Folge der den einzelnen Sendern individuell zugeordneten lokalen AFs ausgestrahlt, d.h. die Gesamt-AF-Liste besteht aus einer Anzahl lokaler Unterlisten, die jede für sich mit einem Code für die Anzahl der AFs beginnt, gefolgt von der Frequenz des Muttersenders, für den die lokale Liste gilt, und die anschließend in Zweier-Blöcken jeweils im Wechsel mit der Frequenz des Muttersenders eine alternative Frequenz ausweist. Die Anzahl der Unterlisten entspricht der Anzahl der Sender einer Programmkette, deswegen erscheinen die Frequenzen der Muttersender auch wieder als AFs in den Unterlisten anderer Muttersender.

Mit der Hilfsträgerfrequenz wird die Hauptträgerwelle der Rundfunksendung frequenzmoduliert, und auf diese Weise werden die RDS-Signale kontinuierlich zusammen mit dem laufenden Programm vom Sender ausgestrahlt. Durch die Übermittlung alternativer Frequenzen ermöglicht das Radiodatensystem die automatische Umschaltung des Empfangsgerätes ohne Programmwechsel auf eine besser empfangbare Frequenz, sobald die ursprünglich gewählte Frequenz nicht mehr empfangswürdig ist.

Aus der EP 0 305 172 A2 ist ein RDS-Rundfunkempfänger bekannt, welcher Stationstasten aufweist. Als Kriterium, welche Empfangsfrequenzen in dem einer Stationstaste zugeordneten Speicher abgespeichert werden, dient der Programmidentifikations-Code. Sobald eine Übereinstimmung besteht zwischen empfangenem Programmidentifikations-Code und einem einer Stationstaste zugeordneten Programmidentifikations-Code, wird die Liste alternativer Frequenzen dieser Stationstaste durch die empfangenen AF-Daten neu festgelegt. Wird die Empfangsfeldstärke geringer, wird auf eine der übertragenen alternativen Frequenzen gewechselt. Zusätzlich wird bei einer generischen Übereinstimmung von übertragenem und in einem jeder Sationstaste zugeordneten Dienste-Speicher gespeicherten Programmidentifikations-Code ein Speicherinhalt mit alternativen Diensten entsprechend den übertragenen Daten neu festgelegt.

Um die vollständige AF-Liste einer Programmkette mit den Rundfunkwellen zu übertragen, werden u.U. bis zu 45 Sekunden benötigt, wobei ein störungsfreier Empfang gewährleistet sein muß. Andernfalls verlängert sich die Übertragungszeit erheblich.

Beim spontanen Abruf eines bestimmten Programms durch Drücken der zugeordneten Programmtaste am Gerät sollen aber, unabhängig davon, in welchem lokalen Sendegebiet sich der Rundfunkhörer aufhält, sofort alternative Frequenzen zur Verfügung stehen, damit ein notwendiger Frequenzwechsel möglichst verzögerungsfrei und unhörbar erfolgen kann.

Für diesen Fall ist es vorteilhaft, auf bereits gespeicherte und zuvor schon einmal auf PI-Code und Empfangsqualität getestete alternative Frequenzen zurückgreifen zu können.

Die Aufgabe der vorliegenden Erfindung ist es deshalb, das Zusammenwirken verschiedener Baugruppen in einem RDS-Rundfunkempfänger derart zu gestalten, daß seine Programmspeicher sukzessiv mit einer begrenzten Anzahl bewährter AFs aus dem individuellen regionalen Fahrbereich des mit dem RDS-Empfänger ausgerüsteten Kraftfahrzeuges geladen werden. Dazu werden aus anderen Speichern bzw. Speicherebenen nur AFs in den jeweiligen Programmspeicher übertragen, deren PI-Code mit demjenigen, der dem jeweiligen Programmspeicher zugeordnet ist, übereinstimmt und deren Empfangsqualität bestimmte Mindestanforderungen erfüllt.

Der über einen längeren Zeitraum aufgebaute Speicherinhalt der Programmspeicher soll auch bei Ausfall der Versorgungsspannung nicht verloren gehen.

Eine weitere Aufgabe der Erfindung ist es, beim Aufruf eines mit PI-Code und AF-Daten belegten Programmspeichers nach dem Kopieren seiner gespeicherten Daten in einen Arbeitsspeicher (erste Speicherebene des RAM-Speichers) sämtliche AFs hinsichtlich ihrer Empfangsqualität und ihres PI-Codes zu überprüfen und in ihrer Rangfolge zu sortieren. Für die anschließende Rundfunkwiedergabe soll der Empfänger auf die Frequenz mit der größten Feldstärke abgestimmt werden.

Ferner liegt der Erfindung die Aufgabe zugrunde, in einer zweiten Speicherebene des RAM-Speichers einen Zusatzsspeicher für eine RDS-Suchlauf-Routine zur Verfügung zu stellen, die auf Tastendruck eingeleitet werden kann. Bei dieser RDS-Suchlauf-Routine werden sämtliche, an einem Empfangsort aktuell empfangbaren RDS-Senderfrequenzen ermittelt und nach PI-Code sortiert im Zusatzspeicher abgelegt.

Dadurch steht für den Empfang in einem Gebiet außerhalb der heimatlichen Programmkette (z. B. Urlaubsgebiet) ein unabhängiger RDS-Senderspeicher zur Verfügung, so daß die mit heimatlichen Sendefrequenzen belegten Programmspeicher nicht gelöscht und vorübergehend neu belegt werden müssen.

Die Aufgabe wird gemäß der Erfindung durch die im Kennzeichen des Patentanspruches 1 genannten Merkmale gelöst. Vorteilhafte Ausgestaltungen der Erfindung sind in den Unteransprüchen dargelegt.

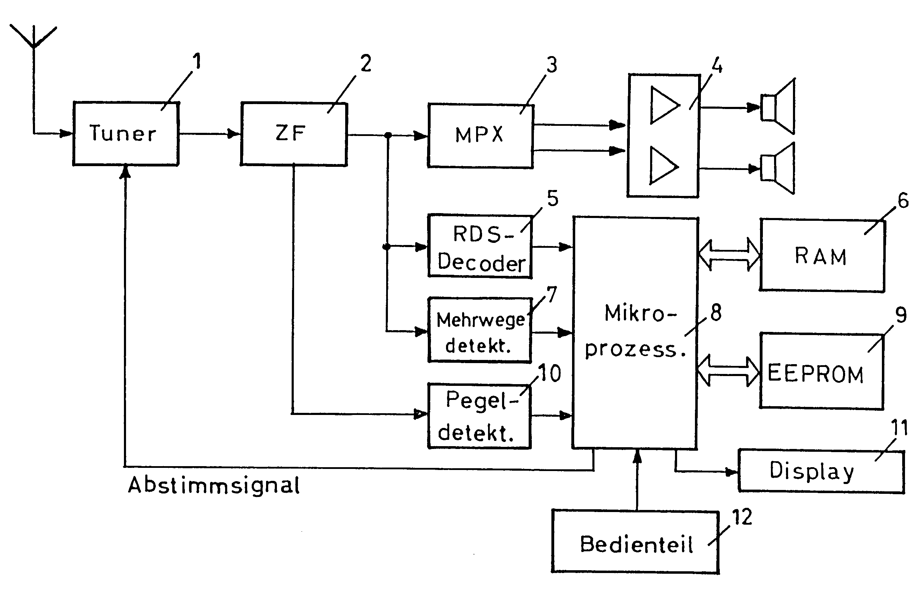

Die Erfindung wird anhand der Zeichnung nachstehend erläutert.

Die Figur zeigt in einem Blockschaltbild ein Ausführungsbeispiel des erfindungsgemäßen RDS-Rundfunkempfängers.

Das RDS-Sendersignal gelangt über die Antenne in den Tuner 1, wird in eine Zwischenfrequenz umgesetzt und im ZF-Verstärker 2 selektiv verstärkt und demoduliert. Im Stereo-Decoder 3 werden aus dem Multiplex-Signal die Audiosignale für den linken und rechten Stereokanal gewonnen, die im Endverstärker 4 verstärkt und den Lautsprechern zugeführt werden. Dem ZF-Verstärker 2 wird nach Maßgabe des ZF-Signalpegels eine Meßgröße zur Feststellung der Signalfeldstärke entnommen, die im Pegeldetektor 10 in ein digitales Steuersignal für den Mikroprozessor 8 gewandelt wird. Außerdem wird aus dem Multiplex-Signal über den Mehrwege-Detektor 7 ein digitales Steuersignal für den Mikroprozessor 8 zur Erkennung von Mehrwegeempfang gewonnen. Der RDS-Decoder 5 wird ebenfalls mit dem demodulierten Multiplex-Signal gespeist. Hier wird nach einer 57 kHz-Bandpaßfilterung das in Quadratur amplitudenmodulierte RDS-Signal demoduliert und die nach einer weiteren Biphase- und Differential-Decodierung gewonnenen digitalen Daten dem Mikroprozessor 8 zugeführt Der Mikroprozessor 8 liefert das Abstimmsignal für den Synthesizer-Tuner 1 und speist das Display 11, über das u.a. die aus dem PS-Code des RDS-Signales gewonnenen Sendernamen alphanumerisch angezeigt werden. Für sämtliche manuellen Bedienfunktionen erzeugt das Bedienteil 12 die entsprechenden Steuerbefehle für den Mikroprozessor 8.

Als Arbeitsspeicher und Zusatzspeicher besitzt der Mikroprozessor 8 einen RAM-Speicher 6 mit mehreren Speicherebenen Der EEPROM-Speicher 9 dient als nichtflüchtiger Programmspeicher, in dessen einzelnen Speicherebenen neben dem PI-Code und dem PS-Code beispielsweise bis zu 24 alternative Frequenzen für jedes Programm abgelegt werden können.

Zur ersten Inbetriebnahme des Empfangsgerätes kann (neben anderen möglichen Bedienabläufen) eine RDS-Suchlauf-Routine eingeleitet werden, bei der sämtliche vor Ort empfangbaren RDS- bzw. RDS-TP-Frequenzen aufgesucht werden. Die gefundenen Frequenzen werden nach PS-Code sortiert in der als Zusatzspeicher fungierenden zweiten Speicherebene des RAM-Speichers 6 abgelegt, wobei jedem PI-Code z. B. max. 3 AFs zugeordnet werden. In unserem Beispiel können bis zu 26 verschiedene Programme (PS-Codes) mit je 3 AFs gespeichert werden. Anschließend überträgt der Mikroprozessor 8 automatisch die Daten des Senders mit der höchsten Feldstärke samt zugehöriger AFs in die als Arbeitsspeicher dienende erste Speicherebene des RAM-Speichers 6 und liefert ein senderbezogenes Abstimmsignal an den Tuner 1.

Sobald die AFs in den Arbeitsspeicher übertragen sind, werden diese durch kurzzeitiges Abstimmen des Empfängers auf die jeweilige Frequenz hinsichtlich ihrer Empfangsqualität überprüft und dementsprechend in der Rangfolge sortiert. Die Programmdaten im Arbeitsspeicher werden dann nach kurzer Zeit mit dem über Wellenausbreitung parallel zum Rundfunkprogramm empfangenen PS-Code und weiteren AFs ergänzt. Bei jedem Frequenzwechsel aufgrund sich verschlechternder Empfangsverhältnisse wird die Qualitätsbewertung und die Rangfolge der alternativen Frequenzen aktualisiert.

Der Zusatzspeicher (zweite Speicherebene des RAM-Speichers 6) kann in einem speziellen Speicher-Abfrage-Modus manuell durch Betätigen einer entsprechend gekennzeichneten Taste schrittweise abgefragt werden, wobei jeweils die Frequenzdaten, wie vorstehend beschrieben, in den Arbeitsspeicher (erste Speicherebene des RAM-Speichers 6) übertragen werden. Die Altdaten des Arbeitsspeichers werden dabei gelöscht.

In diesem Speicher-Abfrage-Modus kann der Zusatzspeicher quasi durchgeblättert werden. Programme, auf die immer wieder zurückgegriffen werden soll, können durch Drücken der entsprechenden Programmtaste in den Programmspeicher 9 übernommen werden. Dabei überträgt der Mikroprozessor 8 den PI-Code, die aktuell eingestellte Senderfrequenz und den PS-Code aus dem Arbeitsspeicher (erste Speicherebene des RAM-Speichers 6) in die der jeweiligen Programmtaste zugeordneten Speicherebene des Programmspeichers 9. Auf diese Weise können sämtliche Programmtasten mit den verschiedenen Programmen (PI-Codes) des heimatlichen Empfangsgebietes belegt werden.

Unabhängig davon kann auch mit speziellen Aufwärts-/Abwärts-Suchlauftasten schrittweise ein manueller Suchlauf eingeleitet werden, bei dem im Arbeitsspeicher (erste Speicherebene des RAM-Speichers 6) nur Sender festgehalten werden, deren RDS-Signale innerhalb von beispielsweise 300 ms dekodierbar sind und die sich z. B. innerhalb von max. 1 s durch einen gültigen PI-Code ausweisen. Auch diese Frequenzen können in der gleichen vorbeschriebenen Weise in den Programmspeicher 9 übernommen werden.

Sobald im Arbeitsspeicher (erste Speicherebene des RAM-Speichers 6) - sei es durch Wechsel auf eine alternative Frequenz wegen Verschlechterung der Empfangsverhältnisse, sei es aufgrund eines manuellen Sendersuchlaufs oder dergleichen - eine Frequenz neu erscheint, deren PI-Code bereits in einer Speicherebene des Programmspeichers 9 vorhanden ist und deren Empfangsqualität bei einem kurzzeitigen Abstimmversuch die Mindestanforderung erfüllt, so wird diese Frequenz in die entsprechende Speicherebene des Programmspeichers 9 durch den Mikroprozessor 8 automatisch übertragen. Dadurch bauen sich in den jeweiligen Programmspeicherebenen sukzessiv begrenzte Listen alternativer Frequenzen auf, die für den Benutzer in Anbetracht seiner üblichen Reiseroute wichtig sind.

Bei Abruf eines bestimmten Programms durch Betätigen der zugehörigen Programmtaste werden durch den Mikroprozessor 8 die in der jeweiligen Speicherebene des Programmspeichers 9 enthaltenen Daten in den Arbeitsspeicher (erste Speicherebene des RAM-Speichers 6) kopiert. Danach werden die AFs durch kurzzeitiges Abstimmen des Empfängers hinsichtlich Feldstärke, Mehrwegeempfang, Sendermitte (zum Ausschluß von Nachbarkanalsendern), RDS-Qualität (Qualitäts-Bit des RDS-Decoders) und PI-Code überprüft und in ihrer Rangfolge entsprechend ihrer Empfangsqualität sortiert. Zum Schluß wird der Empfänger auf die Frequenz mit der höchsten Feldstärke abgestimmt. Die aktuelle Überprüfung nicht nur hinsichtlich der Empfangsqualität sondern auch auf PI-Code ist notwendig, da in einem vom Heimatort entfernten Sendegebiet sich eine Sendefrequenz unter anderem PI-Code, d.h. mit anderem Programm wiederholen kann.

Durch die gezielte Auswahl alternativer Frequenzen in den Programmspeichern, die nur empfangswürdige Frequenzen bestimmter, wiederkehrender Reiserouten enthält, ist bei einem spontanen Programmabruf ein schneller Senderzugriff möglich, da relativ wenige AFs auf ihre Empfangsqualität durch kurzzeitiges Abstimmen des Empfängers überprüft werden müssen.

Der sukzessiv aufgrund der befahrenen Reiserouten aufgebaute Speicherinhalt der Programmspeicher sollte natürlich nur dann gelöscht werden, wenn ein anderes Programm gespeichert werden soll. Vorzugsweise ist deshalb ein nichtflüchtiger Speicher für die Programmspeicher zu verwenden, so daß bei Ausfall der Versorgungsspannung die gespeicherten Daten erhalten bleiben.

## Patentansprüche

1. RDS-Rundfunkempfänger, insbesondere RDS-Autoradio mit elektronischen Abstimm- und Speicherelementen,
**dadurch gekennzeichnet,**
daß eine Steuereinheit (8) vorgesehen ist, welche alternative Frequenzen (AF) der unter gleichem Programmidentifikations-Code (PI-Code) ausgestrahlten Programme aus anderen Speichern und/oder Speicherebenen eines Arbeitsspeichers (6) dann automatisch in die Programmspeicher (9) einschreibt, wenn die bei einer betriebs- oder routinemäßigen Abstimmung des Empfängers empfangenen Frequenzen als RDS-Sendefrequenzen mit ausreichender Empfangsqualität bestätigt werden, wodurch Speicherinhalte von Programmspeichern (9) empirisch erweitert werden.

2. RDS-Rundfunkempfänger nach Anspruch 1,
**dadurch gekennzeichnet**,
daß Mittel vorgesehen sind, welche bei Abruf eines mit Programmidentifikation-Code (PI-Code) und Daten bezüglich alternativer Frequenzen (AF) belegten Programmspeichers (9) sämtliche bestätigten alternativen Frequenzen (AF) des Speichers bzw. der Speicherebene des Programmspeichers nach dem Kopieren in den Arbeitsspeicher (6) hinsichtlich Feldstärke, Mehrwegeempfang, Sendermitte, RDS-Qualität und Programmidentifikations-Code (PI-Code) überprüfen und daß der Mikroprozessor (8) von den alternativen Frequenzen (AF), welche die Prüfkriterien erfüllen, die Frequenz mit der höchsten Feldstärke zur Abstimmung des Empfängers automatisch auswählt.

3. RDS-Rundfunkempfänger nach Anspruch 1 und/oder 2,
**dadurch gekennzeichnet**, daß als Programmspeicher (9) nichtflüchtige Speicherelemente verwendet werden.

4. RDS-Rundfunkempfänger nach Anspruch 1 bis 3,
**dadurch gekennzeichnet**,
daß ein Zusatzspeicher (6) parallel zu den Programmspeichern (9) zur Verfügung steht, in den sämtliche an einem Empfangsort aktuell empfangbaren RDS-Senderfrequenzen mit zugehörigen alternativen Frequenzen (AF) abgelegt und unabhängig von den Programmspeichern (9) zur Abstimmung des Empfängers abgefragt werden können.

## Claims

1. RDS radio receiver, in particular RDS car radio, having electronic tuning elements and electronic memory elements, characterized in that a control unit (8) is provided which automatically writes alternative frequencies (AF) of the programmes transmitted under the same programme identification code (PI code) into the programme memory (9) from other memories and/or memory levels of a working memory (6) if the frequencies received during an operational or routine tuning of the receiver are confirmed as RDS transmission frequencies having adequate reception quality, as a result of which memory contents of programme memories (9) are empirically extended.

2. RDS radio receiver according to Claim 1, characterized in that means are provided which, when a programme memory (9) loaded with programme identification code (PI code) and data relating to alternative frequencies (AF) is called up, check all the confirmed alternative frequencies (AF) of the memory or of the memory level of the programme memory after they have been copied into the working memory (6) in relation to field strength, multipath reception, transmitter centre, RDS quality and programme identification code (PI code) and in that the microprocessor (8) automatically selects the frequency having the highest field strength from the alternative frequencies (AF) fulfilling the test criteria for tuning the receiver.

3. RDS radio receiver according to Claim 1 and/or 2, characterized in that nonvolatile memory elements are used as programme memory (9).

4. RDS radio receiver according to Claims 1 to 3, characterized in that an additional memory (6) is available in parallel with the programme memories (9), in which additional memory (6) all the RDS transmitter frequencies currently receivable at a reception point, together with associated alternative frequencies (AF) can be stored and scanned independently of the programme memories (9) in order to tune the receiver.

## Revendications

1. Récepteur de radiodiffusion RDS, notamment autoradio RDS comportant des éléments électroniques de réglage d'accord et de mémoire, caractérisé en ce qu'il est prévu une unité de commande (8), qui enregistre automatiquement, dans la mémoire de programmes (9), d'autres fréquences (AF) des programmes émis avec le même code d'identification de programme (code PI) à partir d'autres mémoires et/ou d'autres plans d'une mémoire de travail (6), lorsque les fréquences, qui sont reçues dans le cas d'un réglage d'accord de service ou de routine du récepteur, sont confirmées en tant que fréquences d'émission RDS possédant une qualité de réception suffisante, ce qui permet d'élargir de façon empirique des contenus de mémoires de programmes (9).

2. Récepteur de radiodiffusion RDS selon la revendication 1, caractérisé en ce qu'il est prévu des moyens, qui, lors de l'appel d'une mémoire de programmes (9) occupée par un code d'identification de programme (code PI) et des données concernant d'autres fréquences (AF), contrôlent toutes les fréquences alternatives confirmées (AF) de la mémoire ou du plan de la mémoire de programmes après copiage dans la mémoire de travail (6), et ce en ce qui concerne l'intensité de champ, la réception suivant des trajets multiples, le centre de l'émetteur, la qualité RDS et le code d'identification de programme (code PI) et que le microprocesseur (8) sélectionne automatiquement, parmi les autres fréquences (AF) qui satisfont aux critères de contrôle, la fréquence possédant l'intensité de champ maximale pour le réglage d'accord du récepteur.

3. Récepteur de radiodiffusion RDS selon la revendication 1 et/ou 2, caractérisé en ce qu'on utilise des éléments de mémoire non volatile en tant que mémoire de programmes.

4. Récepteur de radiodiffusion RDS selon les revendications 1 à 3, caractérisé en ce qu'en parallèle avec les mémoires de programmes (9) est branchée une mémoire additionnelle (6), dans laquelle toutes les fréquences d'émission RDS, pouvant être effectivement en un emplacement de réception, peuvent être mémorisées avec d'autres fréquences associées (AF) et peuvent être interrogées indépendamment des mémoires de programmes (9), pour le réglage d'accord du récepteur.
